(19) Europäisches Patentamt
European Patent Office
Office européen des brevets

(11) **EP 1 845 386 A2**

## (12) DEMANDE DE BREVET EUROPÉEN

(43) Date de publication:
**17.10.2007 Bulletin 2007/42**

(51) Int Cl.:
***G01R 31/36*** *(2006.01)*

(21) Numéro de dépôt: **07300873.2**

(22) Date de dépôt: **19.03.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **27.03.2006 FR 0602653**

(71) Demandeur: **PEUGEOT CITROËN AUTOMOBILES S.A.**
**78140 Velizy Villacoublay (FR)**

(72) Inventeurs:
• **Ragot, Franck**
**75009, PARIS (FR)**
• **Gregoire, Gilles**
**78220, VIROFLAY (FR)**

(54) **Procédé et système de détermination de l'état de santé de moyens de stockage d'énergie électrique**

(57) La présente invention concerne un système de détermination de l'état de santé de moyens (10) de stockage d'énergie électrique pour véhicule.

Ce système comprend des moyens (12) d'application d'au moins un courant d'excitation aux moyens de stockage d'énergie électrique, des moyens (16) d'acquisition de la réponse en tension des moyens de stockage d'énergie électrique au ou à chaque courant d'excitation qui leur est appliqué, des moyens (18) de détermination d'une dérivée première et d'une dérivée seconde de ladite réponse en tension au courant d'excitation, et des moyens (20) de détermination de l'état de santé des moyens de stockage d'énergie électrique en fonction des dérivées première et seconde déterminées.

FIG.1

**EP 1 845 386 A2**

**Description**

La présente invention concerne un procédé de détermination de l'état de santé de moyens de stockage d'énergie électrique pour véhicule.

L'état de santé des moyens de stockage d'énergie électrique, par exemple constitués d'une batterie, peut être défini comme le ratio de la capacité maximale de décharge réelle sur la capacité maximale de décharge nominale. Ce ratio est représentatif de leur état d'usure et intervient dans l'état de charge maximal réel des moyens de stockage d'énergie électrique.

Le rôle central des moyens de stockage d'énergie électrique dans un véhicule nécessite de connaître leur état de santé pour des questions de fonctionnement satisfaisant du véhicule puisqu'ils participent notamment au fonctionnement des moyens de motorisation thermique, hybride ou électrique du véhicule par exemple. Il est également nécessaire de connaître leur état de santé pour des questions de sécurité car ils peuvent alimenter en énergie électrique des dispositifs de commande de systèmes de freinages ou de direction par exemple.

Il est connu dans l'état de la technique des systèmes de détermination de l'état de santé de batterie. D'une manière générale, ces systèmes appartiennent à deux classes différentes.

La première classe de systèmes comprend des systèmes qui affectent le fonctionnement de la batterie dont ils déterminent l'état de santé. On peut par exemple citer les systèmes qui nécessitent la décharge complète de la batterie pour calculer son état de santé.

La seconde classe de systèmes comprend des systèmes qui déterminent l'état de santé de la batterie par une séquence de tests longue et/ou complexe. Par exemple, certains systèmes de cette classe calculent l'état de santé de la batterie en déterminant des caractéristiques fréquentielles de son impédance interne. Or ce type de détermination nécessite de manière générale des processus de traitement de données coûteux en temps de calcul de sorte qu'il est difficile de les mettre en oeuvre pour déterminer rapidement l'état de santé de la batterie à moins d'utiliser par exemple un microprocesseur embarqué à forte capacité de calcul.

Le but de la présente invention est de résoudre les problèmes susmentionnés en proposant un procédé de détermination de l'état de santé de moyens de stockage d'énergie électrique pour véhicule ne dégradant pas leur fonctionnement et qui soient rapides et fiables.

A cet effet, l'invention a pour objet un procédé de détermination de l'état de santé de moyens de stockage d'énergie électrique de véhicule, caractérisé en ce qu'il comprend les étapes:

- d'application d'un moins un courant d'excitation aux moyens de stockage d'énergie électrique;
- d'acquisition de la réponse en tension des moyens de stockage d'énergie électrique au ou à chaque courant d'excitation qui leur est appliqué;
- de détermination d'une dérivée première et d'une dérivée seconde de ladite réponse en tension au courant d'excitation; et
- de détermination de l'état de santé des moyens de stockage d'énergie électrique en fonction des dérivées première et seconde déterminées de la réponse en tension au courant d'excitation.

Selon d'autres modes de réalisation :

- l'étape de détermination de l'état de santé des moyens de stockage d'énergie électrique comprend :

    - une première étape de calcul de paramètres d'au moins une droite passant par le point d'instant d'origine de la courbe de la dérivée seconde en fonction de la dérivée première ; et
    - une seconde étape de calcul de l'état de santé des moyens de stockage d'énergie électrique en fonction des paramètres déterminés de la au moins une droite ;

- la au moins une droite est la tangente à ladite courbe au point d'instant d'origine ;
- la au moins une droite passe en outre par un second point de ladite courbe tel que la dérivée première de ce second point est strictement supérieure à celle du point d'instant d'origine ;
- le second point de ladite courbe est le point de ladite courbe le plus proche temporellement du point de l'instant d'origine tel que la dérivée première de ce second point est strictement supérieure à celle du point d'instant d'origine ;
- la première étape de calcul des paramètres de la au moins une droite comprend une étape de détermination d'un ratio signal sur bruit de ladite courbe, et le second point appartient en outre à une portion de ladite courbe dont le ratio signal sur bruit est inférieur à une valeur prédéterminée ;
- la seconde étape de calcul de l'état de santé des moyens de stockage d'énergie électrique comprend :
- une troisième étape de calcul, pour la ou chaque droite, d'un indice représentatif de l'état de santé des moyens de stockage d'énergie électrique ; et

- une quatrième étape de calcul de l'état de santé des moyens de stockage d'énergie électrique en fonction des indices calculés ;
- la troisième étape de calcul de l'indice d'état de santé de la droite consiste à calculer celui-ci selon la relation :

$$IES = aX + b/P$$

où IES est l'indice d'état de santé, P est la pente de la au moins une droite, X est l'abscisse à l'origine de celle-ci, et a et b sont des paramètres prédéterminés ;
- a=0 et b=-1;
- la quatrième étape de calcul de l'état de santé en fonction des indices comprend :

  - une étape de sélection d'un indice parmi les indices calculés ; et
  - une étape de calcul de l'état de santé des moyens de stockage d'énergie électrique en évaluant, pour l'indice sélectionné, une cartographie prédéterminée de valeurs d'état de santé en fonction de valeurs d'indice ;

- il comprend en outre une étape de mémorisation d'au moins une détermination antérieure de l'état de santé des moyens de stockage d'énergie électrique, et l'étape de détermination de l'état de santé de moyens de stockage d'énergie électrique détermine ce dernier en fonction de la au moins une détermination antérieure mémorisée ;
- le au moins un courant est un premier courant et un second courant d'excitation associés à une première cartographie biunivoque prédéterminée de valeurs d'état de santé en fonction de valeurs d'indice et à une seconde cartographie prédéterminée de valeurs d'état de santé en fonction de valeurs d'indice respectivement, en ce que l'étape de détermination de l'état de santé des moyens de stockage d'énergie électrique détermine un premier état de santé pour le premier courant en fonction de la première cartographie, et l'étape de détermination de l'état de santé des moyens de stockage d'énergie électrique détermine un second état de santé pour le second courant en fonction d'une portion biunivoque de la seconde cartographie, cette portion biunivoque étant sélectionnée en fonction du premier état de santé déterminé ; et
- le au moins un courant d'excitation est un courant de décharge des moyens de stockage d'énergie électrique.

L'invention a également pour objet un système de détermination de l'état de santé de moyens de stockage d'énergie électrique de véhicule, caractérisé en ce qu'il comprend :

- des moyens d'application d'au moins un courant d'excitation aux moyens de stockage d'énergie électrique;
- des moyens d'acquisition de la réponse en tension des moyens de stockage d'énergie électrique au ou à chaque courant d'excitation qui leur est appliqué;
- des moyens de détermination d'une dérivée première et d'une dérivée seconde de ladite réponse en tension au courant d'excitation; et
- des moyens de détermination de l'état de santé des moyens de stockage d'énergie électrique en fonction des dérivées première et seconde déterminées.

L'invention sera mieux comprise à la lecture de la description qui va suivre, donnée uniquement à titre d'exemple, et faite en relation avec les dessins annexés dans lesquels :

- la figure 1 est une vue schématique du système de détermination selon l'invention associé à des moyens de stockage d'énergie électrique.
- la figure 2 est une courbe de la variation de la dérivé seconde en fonction de la variation de la dérivé première d'une partie prédéterminée d'une réponse en tension aux bornes des moyens de stockage à un créneau de courant de décharge et la tangente à l'origine de cette courbe ;
- la figure 3 est une portion agrandie de la courbe de la figure 2 ;
- la figure 4 est une portion agrandie d'une autre courbe de variation de la dérivée seconde en fonction de la dérivée première ;
- la figure 5 est une cartographie bijective d'états de santé en fonction d'indices d'état de santé, utilisée par les moyens de comparaison entrant dans la constitution du système de la figure 1 ; et
- la figure 6 est une cartographie non bijective d'états de santé en fonction d'indices d'état de santé, utilisée par les moyens de comparaison entrant dans la constitution du système de la figure 1.

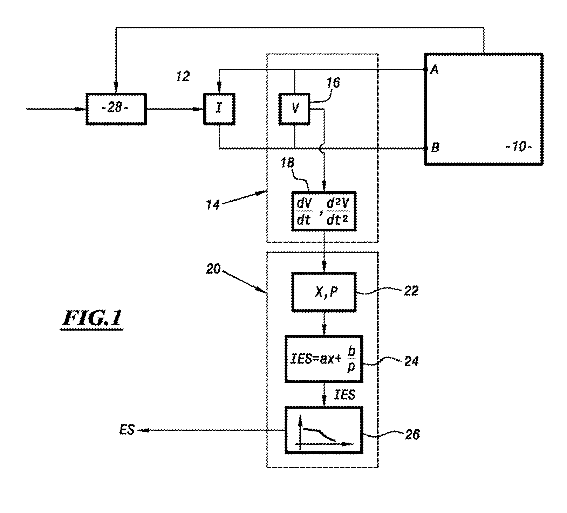

On a illustré sur la figure 1, un système de détermination de l'état de santé de moyens 10 de stockage d'énergie électrique, par exemple une batterie du type plomb-acide liquide.

Le système de détermination comprend, raccordés aux bornes A, B des moyens 10 de stockage, des moyens 12 de décharge des moyens 10 de stockage. Les moyens 12 de décharge sont propres à exciter les moyens 10 de stockage en consommant un courant de décharge prédéterminé 10 sous forme de créneau de courant de durée prédéterminée, par exemple 25 secondes. De manière avantageuse, la durée du créneau du courant de décharge est une fonction décroissante de l'amplitude du créneau.

De préférence, le courant 10 est relativement faible par rapport au courant de décharge maximum que peuvent fournir les moyens 10 de stockage afin de ne pas appliquer de contraintes trop fortes à ces derniers entraînant une dégradation de ceux-ci.

Par exemple, le courant 10 est compris dans la plage [3A ; 60A].

Le système de détermination comprend en outre des moyens 14 d'acquisition raccordés aux moyens 10 de stockage et synchronisés sur les moyens 12 de décharge. Les moyens 14 d'acquisition sont adaptés pour acquérir au moins une caractéristique dynamique de la réponse en tension des moyens 10 de stockage au courant de décharge des moyens 12 de décharge.

Plus particulièrement, les moyens 14 d'acquisition comprennent des moyens 16 de mesure de tension adaptés pour mesurer une réponse en tension V aux bornes des moyens 10 de stockage à l'application du courant de décharge, pour appliquer un filtrage passe-bas à la réponse en tension mesurée, de préférence avec une fréquence de coupure fc sensiblement égale à 5 Hz, et pour échantillonner cette réponse filtrée selon une période d'échantillonnage prédéterminée Te, par exemple égale à 20 millisecondes.

Les moyens 16 de mesure de la réponse en tension comprennent par exemple un capteur de tension classique pour mesurer de façon continue la tension aux bornes des moyens 10 de stockage, un filtre passe-bas analogique raccordé à la sortie du capteur et un convertisseur analogique/numérique raccordé à la sortie du filtre et qui échantillonne la tension continue filtrée selon la période Te.

Les moyens 14 d'acquisition comprennent également des moyens 18 de détermination d'une dérivée temporelle première dV/dt et d'une dérivée temporelle seconde $d^2V/dt^2$ de la réponse numérique en tension V acquise par les moyens 16 de mesure.

Les moyens 18 de détermination des dérivées temporelles sont adaptés pour calculer celles-ci selon les relations :

$$\forall k \geq n, \quad \frac{dV}{dt}(kTe) = \frac{v(kTe) - V((k-n)Te)}{nTe} \qquad (1)$$

$$\forall k \geq 2n, \quad \frac{d^2V}{dt^2}(kTe) = \frac{\frac{dV}{dt}(kTe) - \frac{d^2V}{dt^2}((k-n)Te)}{nTe} \qquad (2)$$

où kTe est le k[ième] instant d'échantillonnage et n est un entier prédéterminé dépendant de l'amplitude du créneau appliqué aux moyens 10 de stockage comme cela sera expliqué plus en détail par la suite.

Les moyens 18 de détermination des dérivées comprennent par exemple deux filtres numériques identiques de dérivation temporelle agencés en série. L'entrée du premier filtre est connectée à la sortie des moyens 16 de mesure et reçoit la tension V échantillonnée, la sortie de ce premier filtre constituant ainsi la dérivée première de la réponse en tension mesurée aux bornes des moyens 10 de stockage. La sortie du premier filtre est connectée à l'entrée du second filtre dont la sortie constitue ainsi la dérivée seconde de cette réponse.

Un autre mode de réalisation des moyens 14 d'acquisition comprend deux filtres analogiques capacitifs branchés aux bornes des moyens 10 de stockage pour acquérir les dérivées première et seconde de la réponse en tension qu'ils délivrent à un convertisseur analogique/numérique pour l'échantillonnage de celles-ci pour un usage ultérieur.

Les dérivées première dV/dt et seconde $d^2V/dt^2$ sont délivrées à des moyens 20 de détermination de l'état de santé des moyens 10 de stockage en fonction de celles-ci.

Les moyens 20 de détermination de l'état de santé comprennent des moyens 22 de traitement adaptés pour déterminer la pente P et l'abscisse X d'une droite passant par le point d'instant d'origine t1 de la courbe de variation de la dérivée seconde en fonction de la dérivée première. Le point d'instant d'origine t1 correspond au premier instant d'échantillonnage t1=2nTe pour lequel la dérivée seconde est calculée.

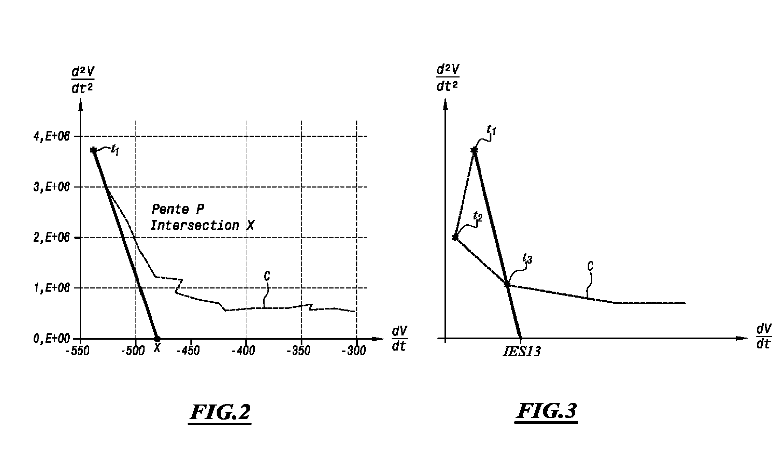

La figure 2 est un exemple de courbe $d^2V/dt^2(kTe) = C(dV/dt(kTe))$ de la variation de la dérivée seconde en fonction de la variation de la dérivée première de la réponse en tension.

Dans une première variante illustrée à la figure 2, les moyens 22 déterminent la droite comme étant la tangente à la courbe C à l'instant t1, c'est-à-dire comme étant la droite passant par les points des deux premiers instants t1=2nTe et t2=(2n+1)Te de la courbe C.

Dans une seconde variante, illustrée à la figure 3 qui est une portion agrandie de la courbe C au niveau de l'instant t1, les moyens 22 sont propres à déterminer la droite passant par le point d'instant d'origine t1 et le premier point tel que la valeur dV(kTe)/dt associée de la dérivée première est inférieure ou égale à la valeur dV(2nTe)/dt de la dérivée première associée à l'instant d'origine t1. Dans l'exemple de la figure 3, il s'agit du point de la courbe C associé au troisième instant t3=(2n+2)Te, la valeur de la dérivée première associée à l'instant t2=(2n+1)Te étant inférieure à celle associée à l'instant t1. Cette variante permet ainsi de s'affranchir de valeurs aberrantes des dérivées, comme celles de l'instant t2, par exemple provoquées par un bruit de mesure.

En se référant de nouveau à la figure 1, les moyens 20 de détermination comprennent des moyens 24 de détermination d'un indice d'état de santé IES, qui reçoivent en entrée la pente P et l'abscisse à l'origine X des moyens 18. Les moyens 24 de détermination de l'indice d'état de santé sont adaptés pour déterminer l'indice d'état de santé IES en fonction la pente P et l'abscisse à l'origine X selon la relation prédéterminée :

$$IES = a.X + b/P$$

où a et b sont des paramètres prédéterminés mémorisés par exemple dans les moyens 24 de détermination de l'indice d'état de santé. De préférence, a = 0 et b=-1.

Les moyens 20 de détermination de l'état de santé comprennent en outre des moyens 26 de comparaison recevant en entrée l'indice d'état de santé IES déterminé par les moyens 24. Ces moyens 26 de comparaison sont propres à comparer l'indice d'état de santé IES à une cartographie prédéterminée d'états de santé pour déterminer l'état de santé ES des moyens 10 de stockage d'énergie électrique. La cartographie est par exemple mise en oeuvre au moyen d'une table de correspondance ou de moyens d'interpolation comme cela est connu en soi dans l'état de la technique.

Dans un autre mode de réalisation, les moyens 22 sont propres à sélectionner N points de la courbe $d^2V/dt^2$(kTe) = C(dV/dt(kTe)) les plus proches du point d'instant d'origine t1, où N est un entier prédéterminé, tels que la valeur de la dérivée première dV(kTe)/dt associée à chacun des points sélectionnés est inférieure ou égale à celle dV(2nTe)/dt associée à l'instant d'origine t1.

Les moyens 22 calculent les paramètres X et P des droites passant respectivement par le point d'instant d'origine t1 et les N points sélectionnés. Les moyens 24 sont alors adaptés pour calculer un indice d'état de santé intermédiaire pour chacune des droites associées aux N points sélectionnés, d'une manière identique à celle décrite précédemment. De préférence, lorsque l'amplitude du courant de décharge est supérieure à 10A, N=10, et sinon N=4.

Dans ce mode de réalisation, les moyens 24 de détermination de l'indice d'état de santé déterminent ce dernier comme étant le minimum des indices d'état de santé intermédiaires calculés.

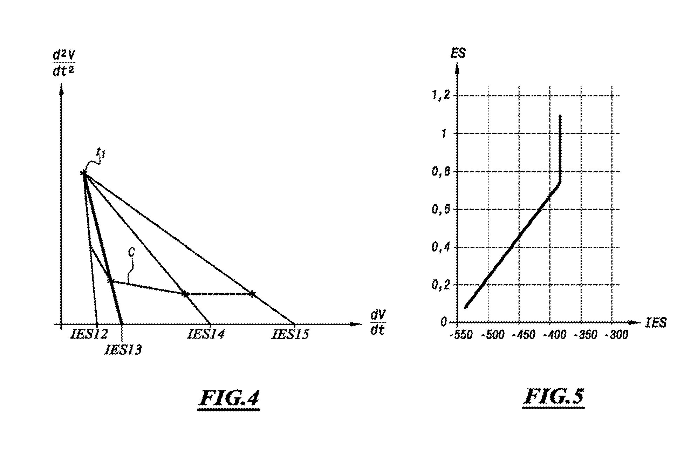

Comme cela est illustré à la figure 4 où N est égal à quatre. Les moyens 22 sélectionnent les quatre points correspondants aux quatre instants suivants l'instant t1 car chacune des valeurs de la dérivée première qui leur est associée est inférieure ou égale à celle associée à l'instant t1. Les moyens 22 calculent les paramètres X et P de chacune des droites passant par le point associé à l'instant t1 et un des points sélectionnés. Les moyens 24 calculent alors en fonction des paramètres des droites des indices d'état de santé intermédiaires IES12, IES13, IES14 respectifs et déterminent l'indice d'état de santé selon la relation IES = min(IES12, IES13, IES14).

En variante, les moyens 22 sont propres à calculer un ratio signal sur bruit de la courbe $d^2V/dt^2$(kTe) = C(dV/dt(kTe)). Plutôt que de sélectionner les N points les plus proches du point d'instant d'origine t1, les moyens 22 sélectionnent les N points dans une portion de la courbe C dont le ratio signal sur bruit est inférieur à une valeur prédéterminée.

La figure 5 est un exemple d'une cartographie bijective d'états de santé en fonction de l'indice d'état de santé. Il s'agit d'une courbe expérimentale, déterminée lors d'une étude antérieure, de l'état de santé ES en fonction de l'indice d'état de santé IES pour un créneau de courant de décharge d'amplitude de 3A appliqué à une batterie du type plomb-acide liquide présentant à l'instant d'application du créneau de courant de décharge un état de charge sensiblement égal à 100%.

Cette courbe illustre le fait qu'il existe pour le créneau de courant susmentionné une relation bijective entre l'indice IES et l'état de santé ES. Ceci permet de déterminer de façon biunivoque, et donc de manière simple, l'état de santé en fonction de l'indice d'état de santé.

Toutefois, on observe que la détermination de l'état de santé ES des moyens 10 de stockage peut s'avérer imprécise lorsqu'un créneau de faible amplitude est utilisé.

L'utilisation de courant de décharge d'amplitude plus élevée permet une détermination plus précise de l'état de santé ES des moyens 10 de stockage d'énergie électrique. Or, pour de tels courants, la relation entre l'état de santé ES et l'indice d'état de santé IES peut devenir non bijective, de sorte que des tests supplémentaires sont nécessaires pour déterminer l'état de santé en fonction de l'indice d'état de santé.

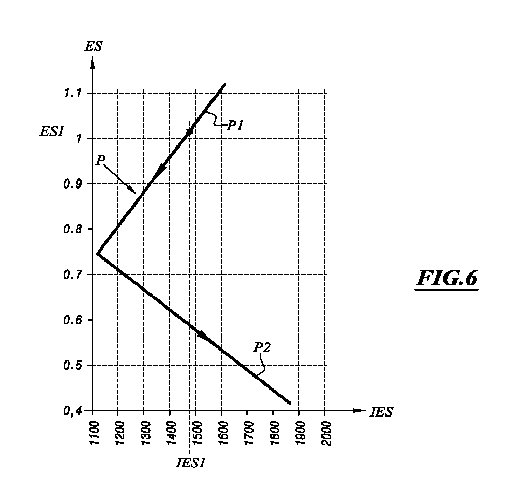

La figure 6 est un exemple de cartographie non bijective d'états de santé ES en fonction d'indices d'état de santé IES. Il s'agit d'une courbe expérimentale, déterminée lors de l'étude antérieure, de l'état de santé ES en fonction de l'indice d'état de santé IES pour un créneau de courant de décharge d'amplitude de 12A appliqué à une batterie du type plomb-acide liquide présentant à l'instant d'application du créneau de courant de décharge un état de charge sensiblement égal à 100%.

La courbe P de cartographie comprend deux portions bijectives P1 et P2. Il est donc associé à chaque valeur d'indice d'état de santé IES deux valeurs de l'état de santé ES. Toutefois, la courbe P est paramétrée par l'état d'usure des moyens 10 de stockage selon le sens des flèches illustrées sur la figure 6. La courbe P est donc paramétrée en fonction du temps.

Dans une première variante, les moyens 26 de comparaison sont propres à mémoriser l'historique des états de santé précédemment déterminés de sorte que la portion de la courbe P déjà parcourue est connue. Les moyens 26 de comparaison sélectionnent ainsi la bonne valeur d'état de santé parmi les deux valeurs possibles en fonction de la portion de courbe déjà parcourue.

Dans une seconde variante, un premier courant de décharge associé à une cartographie bijective, comme celle illustrée à la figure 5, est appliqué aux moyens 10 de stockage par les moyens 12 de décharge. Les moyens 20 déterminent un premier indice d'état de santé IES1 et un état de santé ES1 en fonction du premier indice IES1 à l'aide de la cartographie bijective, comme cela a été décrit précédemment.

Un second courant de décharge associé à une cartographie non bijective comme celle illustrée à la figure 6 est ensuite appliqué par les moyens 12 de décharge aux moyens 10 de stockage. Les moyens 20 déterminent alors un second indice d'état de santé IES2. Les moyens 26 de comparaison sont en outre adaptés pour sélectionner la portion bijective de la cartographie non bijective associée au premier état de santé ES1 déterminé, comme cela est illustré sur la figure 6 dans laquelle la portion P1 est sélectionnée. Les moyens 26 de comparaison utilisent alors ensuite la portion de courbe sélectionnée pour déterminer l'état de santé final en fonction du second indice d'état de santé IES2 calculé.

Lors de l'étude antérieure, pour un courant de décharge donné, plusieurs essais sont réalisés en faisant varier l'entier n utilisé pour calculer les dérivées première et seconde selon les relations (1) et (2) et plusieurs cartographies sont ainsi déterminées. On observe que ce nombre n croit avec l'amplitude du courant de créneau. La cartographie qui donne les estimations de l'état de santé les plus précises est alors finalement sélectionnée, ainsi que le nombre n qui lui est associé. Le nombre n utilisé par les moyens 18 de détermination des dérivées première et seconde est celui associé à la cartographie utilisée par les moyens 22 de comparaison.

Une cartographie d'états de santé ES en fonction d'indices d'états de santé IES dépend de l'état de charge des moyens 10 de stockage dont il convient de connaître la valeur pour utiliser de manière satisfaisante la cartographie.

En se référant de nouveau à la figure 1, le système de détermination comprend des moyens 28 de déclenchement de la détermination de l'état de santé des moyens 10 de stockage. Les moyens 28 sont adaptés pour déterminer l'état de charge des moyens 10 de stockage et pour déclencher la détermination de l'état de santé de ceux-ci lorsque au moins l'état de charge déterminé est égal à l'état de charge associé à la cartographie. Les moyens 28 commandent notamment les moyens 12 d'application du courant de décharge pour que ceux-ci appliquent aux moyens 10 de stockage le courant de décharge associé à la cartographie. Les moyens 28 commandent également les moyens 14 d'acquisition pour qu'ils acquièrent la réponse en tension au courant appliqués et calculent les dérivées temporelles première et seconde de cette réponse en fonction de l'entier n associé à la cartographie.

Un autre mode de réalisation consiste à utiliser un ensemble prédéterminé de cartographies, chacune associée à un état de charge prédéterminé des moyens 10 de stockage. Les moyens 28 de déclenchement sont alors adaptés pour déterminer l'état de charge des moyens 10 de stockage et sélectionner la cartographie correspondante et la délivrer aux moyens 22 de comparaison.

En variante, une cartographie est également déterminée lors de l'étude antérieure en fonction de la température des moyens 10 de stockage d'énergie électrique. Ceux-ci sont associés à un capteur de température et les moyens 28 déclenchent la détermination de l'état de santé des moyens 10 de stockage d'énergie électrique lorsque en outre la température mesurée de ceux-ci correspond à la température associée à la cartographie ou bien les moyens 28 de déclenchement sélectionnent une cartographie de l'ensemble prédéterminé de cartographie correspondant en outre à la température mesurée.

Les moyens 28 de déclenchement sont en outre adaptés pour déclencher la détermination de l'état de santé périodiquement et/ou régulièrement, par exemple à intervalles réguliers ou lorsqu'un nombre prédéterminé de kilomètres a été parcouru par le véhicule depuis la dernière détermination de l'état de santé des moyens 10 de stockage.

Le système de détermination selon l'invention est applicable à des moyens de stockage d'énergie équipant des véhicules par exemple automobile, motocycle, du type thermique, hybride ou électrique, ou autres.

**Revendications**

1. Procédé de détermination de l'état de santé de moyens de stockage d'énergie électrique de véhicule, **caractérisé en ce qu'**il comprend les étapes:

   - d'application d'un moins un courant d'excitation aux moyens de stockage d'énergie électrique ;
   - d'acquisition de la réponse en tension des moyens de stockage d'énergie électrique au ou à chaque courant d'excitation qui leur est appliqué;
   - de détermination d'une dérivée première et d'une dérivée seconde de ladite réponse en tension au courant d'excitation; et
   - de détermination de l'état de santé des moyens de stockage d'énergie électrique en fonction des dérivées première et seconde déterminées de la réponse en tension au courant d'excitation.

2. Procédé selon la revendication 1, **caractérisé en ce que** l'étape de détermination de l'état de santé des moyens de stockage d'énergie électrique comprend :

   - une première étape de calcul de paramètres d'au moins une droite passant par le point d'instant d'origine de la courbe de la dérivée seconde en fonction de la dérivée première ; et
   - une seconde étape de calcul de l'état de santé des moyens de stockage d'énergie électrique en fonction des paramètres déterminés de la au moins une droite.

3. Procédé selon la revendication 2, **caractérisé en ce que** la au moins une droite est la tangente à ladite courbe au point d'instant d'origine.

4. Procédé selon la revendication 2, **caractérisé en ce que** la au moins une droite passe en outre par un second point de ladite courbe tel que la dérivée première de ce second point est strictement supérieure à celle du point d'instant d'origine.

5. Procédé selon la revendication 4, **caractérisé en ce que** le second point de ladite courbe est le point de ladite courbe le plus proche temporellement du point de l'instant d'origine tel que la dérivée première de ce second point est strictement supérieure à celle du point d'instant d'origine.

6. Procédé selon la revendication 4, **caractérisé en ce que** la première étape de calcul des paramètres de la au moins une droite comprend une étape de détermination d'un ratio signal sur bruit de ladite courbe, et **en ce que** le second point appartient en outre à une portion de ladite courbe dont le ratio signal sur bruit est inférieur à une valeur prédéterminée.

7. Procédé selon l'une quelconque des revendications 2 à 6, **caractérisé en ce que** la seconde étape de calcul de l'état de santé des moyens de stockage d'énergie électrique comprend :

   - une troisième étape de calcul, pour la ou chaque droite, d'un indice représentatif de l'état de santé des moyens de stockage d'énergie électrique; et
   - une quatrième étape de calcul de l'état de santé des moyens de stockage d'énergie électrique en fonction des indices calculés.

8. Procédé selon la revendication 7, **caractérisé en ce que** la troisième étape de calcul de l'indice d'état de santé de la droite consiste à calculer celui-ci selon la relation :

$$IES = aX+b/P$$

où IES est l'indice d'état de santé, P est la pente de la au moins une droite, X est l'abscisse à l'origine de celle-ci, et a et b sont des paramètres prédéterminés.

9. Procédé selon la revendication 8, **caractérisé en ce que** a = 0 et b =-1.

10. Procédé selon la revendication 7, 8 ou 9, **caractérisé en ce que** la quatrième étape de calcul de l'état de santé en fonction des indices comprend :

- une étape de sélection d'un indice parmi les indices calculés ; et
- une étape de calcul de l'état de santé des moyens de stockage d'énergie électrique en évaluant, pour l'indice sélectionné, une cartographie prédéterminée de valeurs d'état de santé en fonction de valeurs d'indice.

11. Procédé selon l'une quelconque des revendications précédentes, **caractérisé en ce qu'**il comprend en outre une étape de mémorisation d'au moins une détermination antérieure de l'état de santé des moyens de stockage d'énergie électrique, et **en ce que** l'étape de détermination de l'état de santé de moyens de stockage d'énergie électrique détermine ce dernier en fonction de la au moins une détermination antérieure mémorisée.

12. Procédé selon les revendications 10 et 11, **caractérisé en ce que** le au moins un courant est un premier courant et un second courant d'excitation associés à une première cartographie biunivoque prédéterminée de valeurs d'état de santé en fonction de valeurs d'indice et à une seconde cartographie prédéterminée de valeurs d'état de santé en fonction de valeurs d'indice respectivement, **en ce que** l'étape de détermination de l'état de santé des moyens de stockage d'énergie électrique détermine un premier état de santé pour le premier courant en fonction de la première cartographie, et **en ce que** l'étape de détermination de l'état de santé des moyens de stockage d'énergie électrique détermine un second état de santé pour le second courant en fonction d'une portion biunivoque de la seconde cartographie, cette portion biunivoque étant sélectionnée en fonction du premier état de santé déterminé.

13. Procédé selon l'une quelconque des revendications précédentes, **caractérisé en ce que** le au moins un courant d'excitation est un courant de décharge des moyens de stockage d'énergie électrique.

14. Système de détermination de l'état de santé de moyens (10) de stockage d'énergie électrique de véhicule, **caractérisé en ce qu'**il comprend :

- des moyens (12) d'application d'au moins un courant d'excitation aux moyens de stockage d'énergie électrique;
- des moyens (16) d'acquisition de la réponse en tension des moyens de stockage d'énergie électrique au ou à chaque courant d'excitation qui leur est appliqué;
- des moyens (18) de détermination d'une dérivée première et d'une dérivée seconde de ladite réponse en tension au courant d'excitation; et
- des moyens (20) de détermination de l'état de santé des moyens de stockage d'énergie électrique en fonction des dérivées première et seconde déterminées.

$$IES = ax + \frac{b}{p}$$

**FIG.1**

**FIG.2**

**FIG.3**

FIG.4

FIG.5

FIG.6